# EUROPEAN PATENT APPLICATION

(11) **EP 4 703 898 A1**
(43) Date of publication of application: **04.03.2026**
(21) Application number: 24197822.0
(22) Date of filing: 02.09.2024
(51) Int. Cl.: G06F 15/78

(54) **SENSOR DATA FUSION CHIPLET ARCHITECTURE**

(71) Applicant: Harman Becker Automotive Systems GmbH, 76307 Karlsbad (DE)
(72) Inventor: AMTHOR, Peter, 81827 Munich (DE)
(74) Representative: Rummler, Felix

(57) **Abstract**

An electronic circuit package for data fusion including a substrate, an interposer disposed on the substrate, and one or more first chiplets disposed on the interposer, the one or more first chiplets operable to carry out a first operation. The electronic circuit package including one or more memory chiplets disposed on the interposer, the one or more memory chiplets operable to store data. The electronic circuit package including one or more second chiplets disposed on the interposer, the one or more second chiplets operable to carry out a second operation.

## Description

The present invention relates to an electronic circuit package for data fusion, a system to an electronic circuit package, and to a vehicle with an electronic circuit package.

### BACKGROUND OF THE INVENTION

The demand for high performance computer chips (including integrated circuits (ICs), printed circuit boards (PCBs) and electronic circuit packages) is increasing in consumer electronics. It is common for a single computer chip to perform multiple operations within a computing device. The number of transistors per computer chip has dramatically increased in order to provide such complex computer chips with the increasing desired performance. Current technology prevents transistor size to shrink much further. Therefore, the increased number of transistors has led to computer chips growing to a very large size. Often, this means that a modem complex computer chip requires twice (and sometimes even three or four times) the physical real-estate typically allocated to such a computer chip in a computer device. These overly large complex computer chips are often more fragile than their simpler counterparts, due to the added weight and size that the complex computer chips exhibit on standard electrical connectors and physical fasteners (for example, screws on a computer device). Accordingly, there is a physical limitation on how large complex computer chips can grow. There remains a demand to further increase the capability of computer devices and, this, computer chips.

In the automotive industry, the processing demands on vehicles are similarly increasing at an exponential rate. Current vehicles are expected to capture data from multiple sources, compile this data and to aid the driving experience based on that data. This may include adaptive driving features (such as adaptive cruise control, adaptive lighting, automatic windshield wipers and the like), detection features for the enablement of autonomous driving, playback of music and other content, automatic seat adjustment, etc. Currently, this is either achieved by providing a vehicle with a plurality of separate computer devices, each computer device dedicated to one task. Current systems are difficult to manage, complex and expensive to manufacture, and require a relatively large amount of power to run. These issues are amplified with vehicles that employ artificial intelligence (AI) models to improve their functions. To address these issues, vehicle manufacturers have attempted to provide a single computer device that employs complex computer chips, as described above, to carry out all of the functions of the vehicle. However, due to the bespoke nature of vehicles' functions, current complex computer chips are unable to provide the desired performance required by next-gen vehicles, due in part to their large power requirements and the inability to improve on the performance capabilities due to the complexity of current computer chips.

Accordingly, there is a need in the industry to provide computing means that can efficiently carry out the multiple functions required by next-gen vehicles. It is an aim of this invention to address the above-mentioned issues.

### SUMMARY

To achieve the above objectives, the invention sets out an electronic circuit device for data fusion, a system and a vehicle as in the claims below.

In a preferred embodiment an electronic circuit package for data fusion is provided. The electronic circuit package for data fusion includes a substrate, an interposer disposed on the substrate and one or more first chiplets disposed on the interposer, the one or more first chiplets operable to carry out a first operation. The package includes one or more memory chiplets disposed on the interposer, the one or more memory chiplets operable to store data. The package includes one or more second chiplets disposed on the interposer, the one or more second chiplets operable to carry out a second operation. By separating out multiple operations (for example a first operation and a second operation) of a complex chip into separate chiplets each dedicated to a specific operation, the computing power of each chiplet can be fully dedicated to its dedicated operation. The advantage of such an architecture is that several chiplets can be combined in a package to avoid one large chip (i.e. a complex chip) with bad yield due to its size. Therefore, one chip component (or chiplet) is not restricted by the computational requirements of multiple operations. This is particularly advantageous in the automotive sector where one vehicle is expected to perform multiple operations which are, typically, carried out by multiple different complex chips, electronic control units (ECUs) and the like. For example, a first type of chiplet may be dedicated to receiving data and a second type of chiplet may be dedicated to processing the data (for example, sorting the data, allocating the data to an action, and/or any other processing operation). The first type of chiplet may be manufactured to receive data in an efficient (for example quick and with lower power consumption) manner. However, the first type of chiplet may have adequate hardware to process the data. The second type of chiplet may be manufactured to process data efficiently but may not be capable to receive data efficiently. Thus, specific hardware can be dedicated for each type of chiplet to ensure that each chiplet type is as efficient as possible. Such chiplet types require fewer resources to manufacture due to their requirement to carry out fewer functions. Therefore, they are easier and cheaper to manufacture while ensuring an overall quicker and more efficient processing system. An electronic circuit package comprising multiple chiplet types (i.e. first chiplets, second chiplets and memory chiplets) is advantageous because such a circuit package does not have to be confined to traditional size requirements of complex chips (for example graphics cards, motherboards, and other types of complex chips). Therefore, an electronic circuit package can be provided that has an overall larger processing capacity than current complex chips. Integrating data fusion in the electronic circuit package is advantageous because multiple data sources can be fused to produce more consistent, accurate, and useful information than that provided by one or more individual (raw) data source. The fused data is more informative than the original inputs because it more accurately represents what is occurring around a vehicle.

In an embodiment, the electronic circuit package further includes a first communication infrastructure coupling the one or more first chiplets and the one or more memory chiplets. The one or more first chiplets may be coupled to the first communication infrastructure in parallel. Alternatively, the one or more first chiplets may be coupled to the first communication infrastructure in series. Advantageously, by placing the first chiplets in parallel to the communication infrastructure data, operations carried out by the first chiplet (for example, receiving data) can be done by multiple first chiplets simultaneously, thus increasing the speed at which the first operation is carried out. The parallel communication with the memory chiplets provides the advantage of unimpeded access to store the actions of the first operation on the memory with low latency. By placing the chiplets in series a plurality of first chiplets can be arranged to each perform separate operations in series by passing through each one of the first chiplets before the operation is stored on the one or memory chiplets. This provides an arrangement where storage only occurs once the operation is complete, thus, reducing the amount of storage required by the overall package.

In an embodiment, the electronic circuit package further includes a second communication infrastructure coupling the one or more memory chiplets and the one or more second chiplets. The one or more second chiplets may be coupled to the first communication infrastructure in parallel. Alternatively, the one or more second chiplets may be coupled to the first communication infrastructure in series. Advantageously, by placing the second chiplets in parallel to the communication infrastructure data, operations carried out by the second chiplet (for example, processing data) can be carried out simultaneously by providing each of the second chiplets with the data from the one or more memory chiplets. This reduces overall latency. By placing the second chiplets in series a plurality of second chiplets can be arranged to each perform separate operations in series by passing through each one of the second chiplets before a final operation is carried out. This is advantageous in scenarios where multiple different type of second operations have to be carried out in succession before a final action is taken (for example, multiple different types of sorting data before a request is made to send a message or activate a device), and where it is advantageous to separate each of the second operations out into separate chiplets to ensure that each of the second chiplets is manufactured to efficiently carry out its dedicated operation.

In an embodiment, the one or more first chiplets may each comprise a first processor operable to carry out the first operation, wherein the first operation comprises receiving data. In an embodiment. Advantageously, an electronic circuit package is provide that has dedicated circuitry (the one or more first chiplets) to receiving data (for example, raw data, pre-processed data, or a combination thereof) from automotive systems and to feeding this data into the memory of the electronic circuit package.

In an embodiment, the data may comprise internal sensor data captured by a vehicle (for example, captured by a camera, radar, microphone, temperature, motion sensor or any other type of sensor capturing data within the cabin of the vehicle). The data may comprise external sensor data captured by the vehicle (for example, captured by a camera, radar, LiDAR, infrared, motion, temperature, microphone, or any other type of sensor capturing data occurring outside the vehicle). The data may comprise data captured by the vehicle (for example, data that is not limited to sensor data and includes sound, video, text, or any other type of information received by the vehicle). The data may comprise data received from an external device (for example, received from a user equipment, a network, a server, or any combination thereof that is in communication with the vehicle). The data may comprise any combination as described above.

In an embodiment, the sensor data may include video data, radar data, LiDAR data, or any combination of the above. Advantageously, an electronic circuit package is provided that can receive a large amount of a variety of sensor data. This data is typically collected continuously by vehicles and the provided electronic circuit package, through its use of one or more dedicated first chiplets to receive the sensor data, can quickly and efficiently store this data in the memory to be processed by other circuitry or chiplets. By being able to quickly and efficiently process this data, safe driving can be ensured because less data is lost during collection to system lag.

In an embodiment, the one or more second chiplets may each include a second processor operable to carry out the second operation. The second operation may include classifying the received data into one or more categories, one or more data types, or a combination of the above. Advantageously, an electronic circuit package is provided that can process the large amount of sensor data because the one or more second chiplets are dedicated specifically to the processing (i.e. classifying) of that data. Accordingly, safe driving can be ensured because any action that may need to be taken due to the received sensor data can be taken processed quicker.

In an embodiment, the one or more data types may include video data, sound data, text data, radar data, LiDAR data, or any combination of the above. Advantageously, the data may be sorted to determine specific actions that may need to be taken by the vehicle. In non-limiting examples, video, radar and/or LiDAR data may be related to avoiding a vehicle collision due to conditions sensed outside the vehicle. Sound and/or text data may be related to determining that a driver of the vehicle is in control of the vehicle.

In an embodiment, the one or more categories may include data comprising information on a user of a vehicle (for example, personal data, medical data), data comprising information on the state of the vehicle (for example, speed, location), detection of one or more moving objects outside of the vehicle (for example, other vehicles, pedestrians, animals), detection of one or more stationary objects outside of the vehicle (for example, lamp posts, parked vehicles), detection of one or more moving objects inside the vehicle (for example, user, passengers, body parts of user(s) if having a medical episode/seizure etc.), detection of one or more stationary objects inside the vehicle (for example, detecting when a component has fallen off), or any combination of the above. Advantageously, various collisions or other malfunctions can be determined efficiently and quickly to avoid, for example, a collision of the vehicle.

In an embodiment, the electronic circuit package may further include one or more third chiplets, the one or more third chiplets disposed on the interposer and coupled to the second communication infrastructure. The one or more third chiplets may each include a processor operable to carry out a third operation. The third operation may include receiving the classified data, determining, from the classified data, that an action is required by the package, and instructing a vehicle to carry out the action. Advantageously, separate chiplets with dedicated processing capacity to determine the type of action required are provided that can more efficiently determine, from the classified data, that an action is required and which action is required. This further increases the safety of the vehicle by ensuring that no system lag is present due to the use of separate and dedicated chiplets for each operation.

In an embodiment, the action includes displaying a message on a user interface, activating a mechanical device, deactivating a mechanical device, activating an electrical device, deactivating an electrical device, requesting data from a network (for example, personal data related to a driver of the vehicle such as if the driver is on any medication and/or has any specific illnesses or other medical conditions), or any combination thereof. Advantageously, a vehicle is provided that can react quicker than a vehicle equipped with multiple complex chips. Furthermore, a vehicle is provided that can carry out multiple operations efficiently and effectively (i.e. with a low failure rate due to time lag and, thus, not being able to receive and/or process data quickly).

In an embodiment, the interposer may include at least one universal plug operable to receive pins from at least one of the one or more first chiplets, the one or more second chiplets, the one or more third chiplets, and the one or more memory chiplets. At least one of the one or more first chiplets, the one or more second chiplets, the one or more third chiplets, and the one or more memory chiplets may include pins operable to engage with the at least one universal plug. This provides a simple approach to replacing broken components of the electronic circuit package compared to current complex chips where multiple chips and circuits are soldered to the circuit board and, thus, when a component is damaged the entire chip has to be replaced. This is advantageous because complex chips, especially those in the automotive industry which often have higher processing requirements and tasks/operations specific to the vehicle, are expensive to replace. Therefore, it is advantageous to have universal plugs to be able to replace individual broken chiplets instead of the full circuit. Furthermore, the provided electronic circuit package can easily be upgraded by replacing chiplets on the system with newer chiplets using a "plug and play" arrangement. This increases the longevity of vehicles on the road by allowing older vehicles with previous generation chiplets to easily be upgraded to include the most modern chiplets. By providing a universal plug, chiplets from multiple manufacturers can be used for the same electronic circuit package which increases the usability of the electronic circuit package.

In a preferred embodiment, a system is provided. The system includes a second substrate, a second interposer disposed on the second substrate, and a plurality of electronic circuit packages as defined above. Accordingly, each of the plurality of electronic circuit packages includes a substrate, an interposer disposed on the substrate and one or more first chiplets disposed on the interposer, the one or more first chiplets operable to carry out a first operation. The package includes one or more memory chiplets disposed on the interposer, the one or more memory chiplets operable to store data. The package includes one or more second chiplets disposed on the interposer, the one or more second chiplets operable to carry out a second operation. Advantageously, multiple electronic circuit packages can be electronically coupled together and can be separated out to perform separate tasks. For example, one electronic circuit package may comprise chiplet types and memory, as described above, to receive sensor data and to process it. A second electronic circuit package may comprise chiplet types and memory dedicated to different operations. Thus, each electronic circuit package may be manufactured to carry out their dedicated tasks efficiently. Therefore, a system can be provided that has an overall even larger processing capacity than current complex chips and current computer systems.

In a preferred embodiment, a vehicle is provided. The vehicle includes a sensor and the electronic circuit package or the system as defined above. Advantageously, the vehicle can detect more information quicker (i.e. without lag) and can process this data quicker (i.e. with less lag) to determine which, if any, actions are required. Thus, a vehicle is provided that is more likely to avoid collisions and any other type of accident and/or malfunction.

In an embodiment, the sensor includes a radar sensor, a LiDAR sensor, a camera sensor for an advanced driver assistance system (ADAS), or any combination of the above.

### BRIEF DESCRIPTION OF THE DRAWINGS

The features, objects, and advantages of the present disclosure will become more apparent from the detailed description set forth below when taken in conjunction with the drawings in which like reference numerals refer to similar elements.
Figure 1a depicts a top-down view of a plurality of chiplets on a substrate, according to the invention;
Figure 1b depicts a side view of the chiplet package on a substrate (a chiplet package), according to the invention;
Figure 2 shows a detailed top-down view of the plurality of chiplets on a substrate (the chiplet package) of Figures 1a and 1b;
Figure 3 shows a top-down view of a system of chiplet packages, according to the invention; and
Figure 4 depicts a vehicle including the chiplet package of Figures 1a, 1b and 2, and the system of chiplet packages of Figure 3, according to the invention.

### DETAILED DESCRIPTION

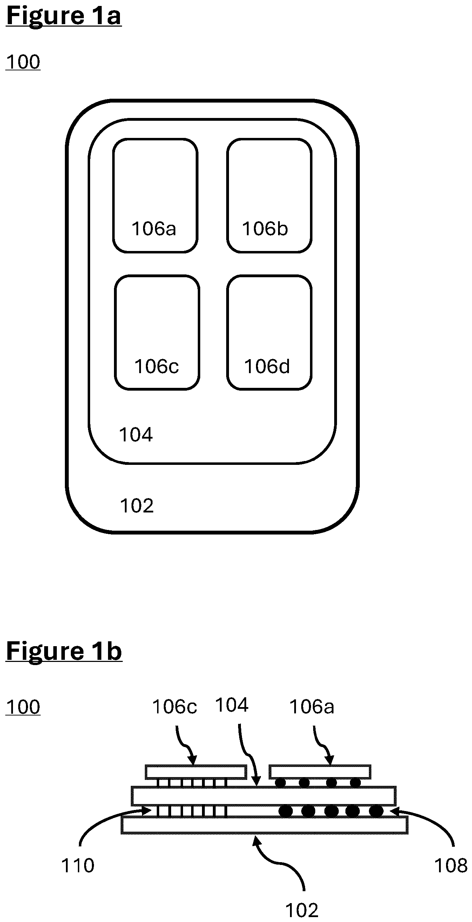

The present invention has to do with a chiplet package, herein referred to as an electronic circuit package, combined with data fusion technology that can provide computing means to efficiently carry out the multiple functions required by next-gen vehicles. Figures 1a and 1b depict a top-down view of a chiplet package (electronic circuit package) 100 and a side view of the chiplet package (electronic circuit package) 100, respectively. The electronic circuit package 100 is for data fusion as described below and may also be a data fusion electronic circuit package. Figure 1a depicts a substrate 102, an interposer 104 and a plurality of chiplets 106a, 106b, 106c, 106d (106a-d).

Substrate 102 is the base material of the electronic circuit package 100. Substrate 102 may be made of a non-conductive material and provide mechanical support and electrical insulation for the interposer 104 and the plurality of chiplets 106a-d. In some embodiments, substrate 102 may comprise one or more electrical connections (for example, to electrically couple the electronic circuit package 100 to an electronic control unit (ECU) of a vehicle).

The interposer 104 may be an electrical interface routing between the plurality of chiplets 106a-d and may also provide electrical interface routing from electrical components outside of the electronic circuit package 100 to the plurality of chiplets 106a-d and to the electrical components outside of the electronic circuit package 100 from the plurality of chiplets 106a-d. The interposer 104 may alternatively or additionally provide electrical interface routing the one or more electrical connections of the substrate 102.

Each of chiplets 106a-d are small integrated circuits (IC) that each comprise one or more processors and are each operable to carry out a well-defined subset of functionality. Each of chiplets 106a-d is designed to carry out a different well-defined subset of functionality. Together, the set of chiplets 106a-d carry out a full task typically carried out by a single (complex) integrated circuit operable to carry out a full set of functionalities. For example, a complex integrated circuit may be operable to receive data, store the data, receive instructions, and carry out an action based on the received data and the received instructions. An electronic circuit package 100 comprising chiplets 106a-d may carry out the same functions but, instead of carrying out those functions on a single integrated circuit splits out the functions to separate chiplets 106a. For example, chiplet 106a may be configured to receive data, chiplet 106b may be configured to receive instructions, chiplet 106c may be configured to determine what action needs to be taken (based on the data and the instructions) and chiplet 106d may be configured to carry out the action. Although four chiplets 106a-d are shown in figure 1a, the invention is not limited to four chiplets and may include two chiplets, three chiplets or any number of chiplets.

The electronic circuit package 100 may include a plurality of chiplets corresponding to the number of operations required by a data fusion model. Data fusion is the process of integrating multiple data sources to produce more consistent, accurate, and useful information than that provided by any individual (raw) data source. A data fusion model is an arrangement that utilises one or more data fusion processes. Data fusion processes may be categorized as low, intermediate, or high, depending on the processing stage at which fusion takes place. Low-level data fusion combines several sources of data (for example, sensor data captured by a vehicle, such as video and sound data) to produce new intermediate-level data (for example, a combination of specific of the video and sound data) which has been fused by the low-level data. The data combined by the low-level data fusion may be raw data captured by the vehicle, pre-processed data (for example, raw data that has been processed by a digital signal processing (DSP) operation, text data, any other type of pre-processed data, or any combination thereof). The intermediate data may be fused again to produce new high-level data (for example, only showing specific colours and specific sound frequency ranges of the fused video and sound data). The fused data may be more informative than the original inputs because it more accurately represents what is occurring around a vehicle. Although three levels are described (low, intermediate and high), a data fusion model may include any number of levels. The electronic circuit package 100 may include at least one chiplet 106a-d for each level. The electronic circuit package 100 may include additional chiplets 106a-d for memory functions (for example, memory chiplets to store data and/or instructions).

In an embodiment, the data collected by the one or more first chiplets 106 may comprise internal sensor data captured by a vehicle (for example, captured by a camera, radar, microphone, temperature, motion sensor or any other type of sensor capturing data within the cabin of the vehicle). The data may comprise external sensor data captured by the vehicle (for example, captured by a camera, radar, LiDAR, infrared, motion, temperature, microphone, or any other type of sensor capturing data occurring outside the vehicle). The data may comprise data captured by the vehicle (for example, data that is not limited to sensor data and includes sound, video, text, or any other type of information received by the vehicle). The data may comprise data received from an external device (for example, received from a user equipment, a network, a server, or any combination thereof that is in communication with the vehicle). The data may comprise any combination as described above.

The data fusion processes may be categorized with numerical levels, a low number corresponding to a lower level processing stage and a higher number corresponding to a higher level processing stage. For example, a level 0 (zero) processing stage may be a source (pre)processing stage. This may be an initial stage (level) at which input data (for example, sensor data captured by a vehicle as described herein) is captured. At level 0, preliminary filtering of the input data may be provided. This may include assorting data from multiple sensors (for example, video sensors, audio sensors, and any other type of sensor) by observation time, reported location, data or sensor type, and uniformity of data units. This may also be referred to as signal level fusion. A level 1 processing stage (i.e. a stage that is higher than level 0) may be an object refinement processing stage. This stage may combine positional and identity information from multiple sensors and set up a refined database of attributes (for example, identified entities/objects within or outside of the vehicle), position (of the vehicle), velocity (of the vehicle), and target tracks (for example, where a vehicle should be positioned). This stage may also be referred to as feature level fusion). A level 2 processing stage (i.e. a stage that is higher than level 1 and level 0) may be a situation refinement. This stage may filter the data to understand the context of the detected objects, focusing on the relationship among objects as well as that between the objects and environment. This stage may also be referred to as decision level fusion. A level 3 processing stage (i.e. a stage that is higher than level 2, level 1, and level 0) may be a threat refinement. At this stage, the current situation (of, for example, objects/environment) may be drawn into the future to describe inferences about threats and vulnerabilities (for example, determining a potential collision or other danger). At this stage it may be determined that an action is required (as described in more detail herein). This stage may also be referred to as decision level fusion. A level 4 processing stage (i.e. a stage that is higher than level 3, level 2, level 1, and level 0) may be a process refinement. At this stage additional processes (for example, actions or filtering) may be performed with the aim to optimize the ongoing data fusion process. Not all of the levels described above have to be taken by the electronic circuit package 100. Instead, the electronic circuit package 100 may utilise two or more levels. Intermediate levels may be skipped or not included if they are not required (for example, an electronic circuit package 100 may utilise level 0 and level 3 only). In an example, the data fusion model may be a JDL (Joint Director of the Labs) model, a DFIG (Data Fusion Information Group) model, or any other suitable data fusion model.

The interposer 104 may be disposed on the substrate 102. The electrical connections coupling the interposer 104 and the substrate 102 may be made with one or more fixed electrical connections as depicted by 108 or any other suitable type of soldering. This provides a strong physical and electrical bond, ensuring that the interposer 104 and the substrate 102 are physically stable components. Alternatively, the electrical connections coupling the interposer 104 and the substrate 102 may be made with one more pins and corresponding plugs as depicted by 110. The pins may form part of the interposer 104 and may protrude from a bottom side of the interposer to interact with a plug on a top side of the substrate 102. Alternatively, the interposer 104 may comprise a plug on a bottom side of the interposer to interact with a plurality of pins protruding from a top side of the substrate 102. The plug on either the substrate 102 or the bottom side of the interposer 104 may be a universal plug operable to receive pins from a plurality of different arrangements. This provides a simple approach to replacing components of the electronic circuit package compared to current complex chips where multiple chips and circuits are soldered to the circuit board and, thus, when a component is damaged the entire chip has to be replaced. This is advantageous because complex chips, especially those in the automotive industry which often have higher processing requirements and tasks/operations specific to the vehicle, are expensive to replace. Therefore, it is advantageous to have universal plugs to be able to replace individual broken chiplets instead of the full circuit. Furthermore, the provided electronic circuit package can easily be upgraded by replacing chiplets on the system with newer chiplets using a "plug and play" arrangement. This increases the longevity of vehicles on the road by allowing older vehicles with previous generation chiplets to easily be upgraded to include the most modern chiplets.

The plurality of chiplets 106a-d may be disposed on the interposer 104. The electrical connections coupling the chiplets 106a-d to the interposer 104 (and, thus, to each other and also to the substrate 102) may be made with one or more fixed electrical connections (for example, any suitable type of soldering or other type of fixed electrical connection) as depicted by 108. This provides a strong physical and electrical bond, ensuring that the interposer 104 and the one or more chiplets 106a-d are physically stable components. Alternatively, the electrical connections coupling the chiplets 106a-dand the interposer 104 may be made with one more pins and corresponding plugs as depicted by 110. The pins may form part of the interposer 104 and may protrude from a top side of the interposer to interact with a plug on a bottom side of the one or more chiplets 106a-d. Alternatively, the interposer 104 may comprise a plug on a top side of the interposer 104 to interact with a plurality of pins protruding from a bottom side of the one or more chiplets 106a-d. The plug on either the top side of the interposer 104 or the bottom side of the one or more chiplets 106a-d may be a universal plug operable to receive pins from a plurality of different arrangements. As described above, this provides a simple approach to replacing broken components of the electronic circuit package compared to current complex chips where multiple chips and circuits are soldered to the circuit board and, thus, when a component is damaged the entire chip has to be replaced. This is advantageous because complex chips, especially those in the automotive industry which often have higher processing requirements and tasks/operations specific to the vehicle, are expensive to replace. Therefore, it is advantageous to have universal plugs to be able to replace individual broken chiplets instead of the full circuit. Furthermore, the provided electronic circuit package can easily be upgraded by replacing chiplets on the system with newer chiplets using a "plug and play" arrangement. This increases the longevity of vehicles on the road by allowing older vehicles with previous generation chiplets to easily be upgraded to include the most modern chiplets.

In an embodiment, one or more of the chiplets (for example, 106a and 106b) may comprise a fixed electrical connections or similar connection as depicted by 108. One or more other chiplets (for example, 106c and 106d) may comprise a plug and pin type connection as depicted by 110.

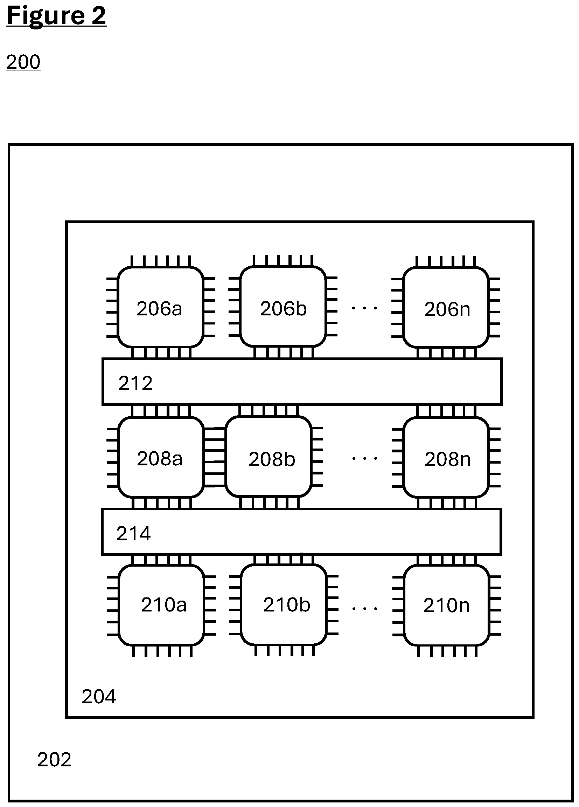

Figure 2 shows a detailed top-down view of an electronic circuit package 200 which is similar to the electronic circuit package 100 of Figures 1a and 1b. The electronic circuit package 200 is for data fusion as described below and may also be a data fusion electronic circuit package. The electronic circuit package 200 includes a substrate 202 (similar to substrate 102 of figures 1a and 1b), an interposer 204 (similar to interposer 104 of figures 1a and 1b) disposed on the substrate 202 in a similar manner as described above with reference to figures 1a and 1b. The electronic circuit package 200 includes one or more first chiplets 206a, 206b, ..., 206n (herein referred to as 206) operable to carry out a first operation, one or more memory chiplets 208a, 208b, ..., 208n (herein referred to as 208) operable to store memory and one or more second chiplets 210a, 210b, ..., 210n (herein referred to as 210) operable to carry out a second operation that is different to the first operation. Although a plurality of first chiplets 206, a plurality of memory chiplets 208 and a plurality of second chiplets 210 are shown, the invention is not limited to the plurality of those chips. The invention may include any denomination (including only one) of first chiplet 206, memory chiplet 208 and second chiplet 210 and any combination thereof. The one or more first chiplet 206 and the one or more second chiplets 210 are similar to the plurality of chiplets 106a-d described above. Similarly, the one or more memory chiplets 208 described are similar to the plurality of chiplets 106a-d described above. The one or more first chiplets 206, the one or more memory chiplets 208 and the one or more second chiplets 210 are disposed on the interposer 204 as described above with regard to figures 1a and 1b. The one or more second chiplets 210 may include a second chiplet 210a operable to perform an intermediate-level operation, a different second chiplet 210b operable to perform a high-level operation, a further different second chiplet 210n operable to perform a higher-level operation, or any combination thereof. Therefore, the one or more first chiplets 206 may be of a first predefined type and the one or more second chiplets 210 may be of a second predefined type. However, the one or more second chiplets may each also be of a different predetermined type (for example, second chiplet 210a may be of a second predetermined type, second chiplet 210b may be of a third predetermined type, second chiplet 210n may be of the second predetermined type, the third predetermined type, a fourth predetermined type, or an n-th predetermined type).

The electronic circuit package 200 may be configured to perform operations of a data fusion model as set out above. Therein, the first operation performed by the one or more first chiplets 206 may include performing a low-level operation, such as receiving/collecting data (for example, sensor data collected by sensors of a vehicle). In an embodiment, the data may comprise internal sensor data captured by a vehicle (for example, captured by a camera, radar, microphone, temperature, motion sensor or any other type of sensor capturing data within the cabin of the vehicle). The data may comprise external sensor data captured by the vehicle (for example, captured by a camera, radar, LiDAR, infrared, motion, temperature, microphone, or any other type of sensor capturing data occurring outside the vehicle). The data may comprise data captured by the vehicle (for example, data that is not limited to sensor data and includes sound, video, text, or any other type of information received by the vehicle). The data may comprise data received from an external device (for example, received from a user equipment, a network, a server, or any combination thereof that is in communication with the vehicle). The data may comprise any combination as described above. This may include raw data, pre-processed data, or a combination thereof.

The first operation may be a level 0 processing stage as described above. The one or more memory chiplets 208 may store the data. The second operation performed by the one or more second chiplets 210 may include performing an intermediate-level operation and/or a high-level operation, as described above. This may include processing the data and determining that an action is required. By separating out multiple operations (for example a first operation and a second operation) of a complex chip into separate chiplets 206, 208, 210 each dedicated to a specific operation, the computing power of each chiplet can be fully dedicated to its dedicated operation. The second operation may be a level 1, level 2, level 3, or level 4 processing stage as described above. In an embodiment, one of a plurality of second chiplets 210 may carry out a level 1 operation, a different one of the plurality of second chiplets 210 may subsequently carry out a level 2 operation, yet a different one of the plurality of second chiplets 210 may subsequent to the level 2 operation carry out a level 3 operation as described above. The advantage of such an architecture is that several chiplets 206, 208, 210 can be combined in a package 200 to avoid one large chip (i.e. a complex chip) with bad yield due to its size. Therefore, one chip component (or chiplet) 206, 208, 210 is not restricted by the computational requirements of multiple operations. For example, a first type of chiplet 206 may be dedicated to receiving data and a second type of chiplet 210 may be dedicated to processing the data (for example, sorting the data, allocating the data to an action, and/or any other processing operation). The first type of chiplet 206 may be manufactured to receive data in an efficient (for example quick and with lower power consumption) manner. However, the first type of chiplet 206 may have adequate hardware to process the data. The second type of chiplet 210 may be manufactured to process data efficiently but may not be capable to receive data efficiently. Thus, specific hardware can be dedicated for each type of chiplet 206, 208, 210 to ensure that each chiplet type 206, 208, 210 is as efficient as possible. Such chiplet types require fewer resources to manufacture due to their requirement to carry out fewer functions. Therefore, they are easier and cheaper to manufacture while ensuring an overall quicker and more efficient processing system. An electronic circuit package 200 comprising multiple chiplet types (i.e. first chiplets 206, second chiplets 210 and memory chiplets 208) is advantageous because such a circuit package does not have to be confined to traditional size requirements of complex chips (for example graphics cards, motherboards, and other types of complex chips). Therefore, an electronic circuit package 200 can be provided that has an overall larger processing capacity than current complex chips.

Figure 2 shows a first communication infrastructure 212 and a second communication infrastructure 214. The first communication infrastructure 212 and the second communication infrastructure 214 provide inter-chiplet communication (for example, communication between the one or more first chiplets 206, the one or more memory chiplets 208, the one or more second chiplets, and/or any other components part of the system 200). The inter-chiplet communication may include wiring harnesses, bus connections, electrical couplings, etched electrical connections on the interposer 204, vias in the interposer 204 coupled to etched electrical connections on the substrate 202, or any other suitable electrical connection.

The first communication infrastructure 212 may couple the one or more first chiplets 206 and the one or more memory chiplets 208. In an embodiment, the one or more first chiplets 206 represent level 0 chiplets (or low-level chiplets) of a data fusion system and are operable to receive and/or collect (raw) data (for example, sensor data from a vehicle). In an embodiment, the number of first chiplets 206 may correlate to the number of sensor inputs required by the system. For example, a system receiving sensor data from three sensors may include three first chiplets 206, one separate first chiplet 206 dedicated to each of the three sensors. The one or more first chiplets 206 may be coupled to the first communication infrastructure 212 in parallel. Advantageously, by placing the first chiplets 206 in parallel to the first communication infrastructure 212, operations carried out by the first chiplets 206 (for example, receiving data) can be done by multiple first chiplets 206 simultaneously, thus increasing the speed at which the first operation is carried out. The parallel communication with the memory chiplets 208 provides the advantage of unimpeded access to store the actions of the first operation (for example, the receiving of data from the one or more first chiplets 206) on the memory 208 with low latency. This also provides the option of each of the plurality of first chiplets 206 being dedicated to collecting a specific type of data (for example, sensor data) and allowing all of the data to be stored on the one or more memory chiplets 208 simultaneously (thus ensuring that each of the first chiplets 206 can flawlessy receive the data it is preprogrammed to receive and that all of the data is stored with low levels of data corruption).

Alternatively, the one or more first chiplets 206 may be coupled to the first communication infrastructure in series. By placing the first chiplets 206 in series a plurality of first chiplets 206 can be arranged to each perform separate operations in series by passing through each one of the first chiplets 206 before the operation is stored on the one or memory chiplets 208. This provides an arrangement where storage only occurs once the operation is complete, thus, reducing the amount of storage required by the overall package. This can be advantageous when the plurality of first chiplets 206 are each performing early stage processing on the collected data, such as digital signal processing. Advantageously, the data stored on the one or more memory chiplets 208 is pre-processed which frees up processing power for the one or more second chiplets 210 to perform their processing operation(s).

In an embodiment, the second communication infrastructure 214 may couple the one or more memory chiplets 208 and the one or more second chiplets 210. The one or more second chiplets 210 may be coupled to the first communication infrastructure in parallel. Advantageously, by placing the second chiplets 210 in parallel to the second communication infrastructure 214, operations carried out by the second chiplet 210 (for example, processing data) can be carried out simultaneously by providing each of the second chiplets 210 with the data from the one or more memory chiplets 208. This reduces overall latency.

Alternatively, the one or more second chiplets 210 may be coupled to the first communication infrastructure 212 in series. By placing the second chiplets 210 in series a plurality of second chiplets 210 can be arranged to each perform separate operations (for example, a second operation, a third operation, a fourth operation, an n-th operation, or any combination thereof as described above) in series by passing through each one of the second chiplets 210 before a final operation is carried out. This is advantageous in scenarios where multiple different type of second operations (for example, a second operation, a third operation, a fourth operation, an n-th operation, or any combination thereof as described above) have to be carried out in succession before a final action is taken (for example, multiple different types of sorting data before a request is made to send a message or activate a device), and where it is advantageous to separate each of the second operations out into separate chiplets to ensure that each of the second chiplets is manufactured to efficiently carry out its dedicated operation.

The one or more memory chiplets 208 are electrically coupled to each other to form a singular memory bank dedicated to storing the data provided by the one or more first chiplets 206, and to provide the data to the one or more second chiplets 210. The number of memory chiplets 208 is determined based on the requirement of the system and can include a singular memory chiplet 208 or any number of memory chiplets 208.

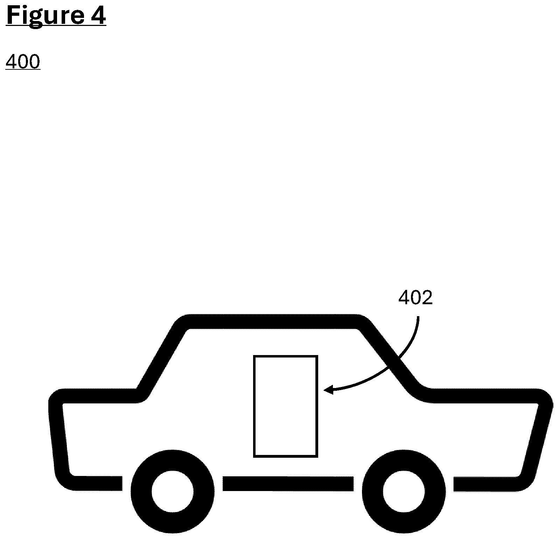

The one or more first chiplets 206 may each comprise a processor (for example, a microcontroller unit (MCU) or any other suitable type of processor) to carry out the first operation. The first operation may include receiving data (for example, sensor data captured by a vehicle) as described above. The first operation may be a level 0 processing stage as described above. In an embodiment, the data may include sensor data captured by a vehicle (for example, vehicle 400 as described in figure 4). Advantageously, an electronic circuit package 100, 200 is provided that has dedicated circuitry (the one or more first chiplets 206) to receive data from automotive systems and to feed this data into the memory (the one or more memory chiplets 208) of the electronic circuit package 100, 200.

In an embodiment, the sensor data may be include sensor data from external sensors of a vehicle (for example, vehicle 400 as described in figure 4). The external sensors of the vehicle may record video data, radar data, light detection and ranging (LiDAR) data, or any combination of the above. The sensor data may additionally or alternatively include sensor data from internal sensors of the vehicle (for example, in-cabin sensors that can view the passenger(s) of the vehicle, radar detector(s), one or more cameras, temperature sensors, sound sensors, or any other in-cabin sensor). Advantageously, an electronic circuit package 100, 200 is provided that can receive a large amount of a variety of sensor data. This data is typically collected continuously by vehicles (for example, vehicle 400 as described in figure 4) and the provided electronic circuit package 100, 200, through its use of one or more dedicated first chiplets 206 to receive the sensor data, can quickly and efficiently store this data in the memory to be processed by other circuitry or chiplets (for example, one or more second chiplets 210). By being able to quickly and efficiently process this data, safe driving can be ensured because less data is lost during collection to system lag. Furthermore, all sensor data recorded by the vehicle can be received, stored and processed by a single system (i.e. the electronic circuit package 100, 200). This provides a simple solution to the automotive industry where fewer computing requirements (i.e. fewer processing devices) are required for the sensing and processing of data. Furthermore, by combining all sensor data in a single system, multiple actions (for example, accident prevention actions) can be efficiently processed to more accurately to determine a current scenario of the vehicle (and/or the driver of the vehicle). This is more efficient than having multiple systems for collecting and processing sensor data for each sensor type.

The one or more first chiplets 206 may be coupled to the first communication infrastructure 208 in parallel or in series. By placing the one or more first chiplets 206 in parallel, different types of sensor data (for example, video data, radar data, LiDAR data, and/or any other type of data as described above) may be captured simultaneously. By placing the one or more first chiplets 206 in series, different types of sensor data (for example, video data, radar data, LiDAR data, and/or any other type of data as described above) may be captured in a specific order.

In an embodiment, the one or more first chiplets 206 may perform pre-processing of the captured data. This may, for example, include a digital signal processing (DSP) stage where captured sensor signals (for example, voice, audio, temperature, pressure, position, video, and/or any other type of data or combination thereof) are pre-processed and filtered into separate components which are stored in the one or more memory chiplets 208.

The one or more second chiplets 210 may each include a processor (for example, a microcontroller unit (MCU) or any other suitable type of processor) operable to carry out the second operation. The second operation may include classifying the received data into one or more sets of data. The sets of data may include one or more categories, one or more data types, or a combination of the above. Classifying the data may include one or more of the level 1 processing stage, level 2 processing stage, and the intermediate processing stage as described above. This may include receiving the data from the one or more memory chiplets 208 and then processing and merging this data. Advantageously, an electronic circuit package 100, 200 is provided that can process the large amount of sensor data because the one or more second chiplets 210 are dedicated specifically to the processing (i.e. classifying) of that data. Accordingly, safe driving can be ensured because any action that may need to be taken due to the received sensor data can be taken processed quicker.

In an embodiment a level 1 processing stage (and a corresponding second chiplet 210 operable to carry out the level 1 processing stage) may carry out a digital signal processing (DSP) operation.

In an embodiment, the one or more data types may include video data, sound data, text data, radar data, LiDAR data, or any combination of the above. Advantageously, the data may be sorted to determine specific actions that may need to be taken by the vehicle. In non-limiting examples, video, radar and/or LiDAR data may be related to avoiding a vehicle collision due to conditions sensed outside the vehicle. Sound and/or text data may be related to determining that a driver of the vehicle is in control of the vehicle.

In an embodiment, the one or more categories may include data comprising information on a user of a vehicle (for example, personal data, medical data), data comprising information on the state of the vehicle (for example, speed, location), detection of one or more moving objects outside of the vehicle (for example, other vehicles, pedestrians, animals), detection of one or more stationary objects outside of the vehicle (for example, lamp posts, parked vehicles), detection of one or more moving objects inside the vehicle (for example, user, passengers, body parts of user(s) if having a medical episode/seizure etc.), detection of one or more stationary objects inside the vehicle (for example, detecting when a component has fallen off), or any combination of the above. Advantageously, various collisions or other malfunctions can be determined efficiently and quickly to avoid, for example, a collision of the vehicle (such as vehicle 400 described in figure 4).

In an embodiment, the electronic circuit package 100, 200 may further include one or more third chiplets 210b, 210c, ..., 210n, the one or more third chiplets disposed on the interposer 204 and coupled to the second communication infrastructure 214. The one or more third chiplets may be physically similar to the one or more second chiplets 210 and may be coupled to the second communication infrastructure 214 in a similar manner to the one or more second chiplets 210 (for example, in parallel with the one or more second chiplets 210 or in series to the one or more second chiplets 210 and subsequent to the one or more second chiplets 210). The one or more third chiplets may be a subset of the one or more second chiplets 210 and may be of a third predetermined type as described above. The one or more third chiplets may each include a processor (for example, an MCU or any other suitable processor) operable to carry out a third operation. The third operation may include receiving the classified data, determining, from the classified data, that an action is required by the package, and instructing a vehicle to carry out the action. Advantageously, separate chiplets with dedicated processing capacity to determine the type of action required are provided that can more efficiently determine, from the classified data, that an action is required and which action is required. This further increases the safety of the vehicle (for example, vehicle 400 as described in figure 4) by ensuring that no system lag is present due to the use of separate and dedicated chiplets for each operation.

In an example use case, a vehicle (such as vehicle 400 described in figure 4) may receive sensor data. The sensor data may be external sensor data includes one or more of radar (for example, short wave radar, mid-range radar, long range radar, or any other type of radar), LiDAR and data captured from one or more camera sensors (for example for ADAS). All of this sensor data is captured by the one or more first chiplets 206 (for example, a first chiplet 206a for the radar, a different first chiplet 206b for the LiDAR, and yet a different first chiplet 206c for the cameras) and is then stored on the one or more memory chiplets 208. The radar sensor may detect an object (for example, an obstacle on the road) and that data, after it has been collected and stored, would be fed into the one or more second chiplets 210. The one or more second chiplets 210n may track the data associated with that object (for example, in level 1). As the object comes into range of the LiDAR, the sensor data of the LiDAR is captured by the first chiplet 206b and stored in the one or more memory chiplets 208. The data related to the object detection by the LiDAR would then be fed into the one or more second chiplets 210n (for example, in level 1). A different of the one or more second chiplets (for example, a third predetermined type as described above) may receive the data related to the object detected by both the LiDAR and the radar and then classify the object. This may include determining that the object is moving or stationary, determining the speed at which the object is moving towards the vehicle (or the amount of time left before the vehicle would collide with the object). The determination may be fed into a further second chiplet (for example, a chiplet operable to perform a level 2 processing stage) to classify this object and its motion relative to the vehicle as a threat (or a non-threat). When the object comes into the range of the camera, the sensor data of the camera is captured by the first chiplet 206c and stored in the one or more memory chiplets 208. The data related to the object detection by the camera would then also be fed into the one or more second chiplets 210n (for example, in level 1) and subsequently that data would be used to further classify the object. This may include determining that the object is dangerously close to the vehicle. This determination may also be fed into the further second chiplet (i.e. the second chiplet operable to perform the level 2 processing stage). At this stage, an even higher level second chiplet (for example, a second chiplet operable to perform a level 3 processing stage) where an action is required. The action may be to indicate a warning to the user of the vehicle, to apply the brakes and/or the steering of the vehicle, or similar.

Another example case could include the capture of sensor data from within a cabin of a vehicle (such as vehicle 400 as described in figure 4). This may include capturing various types of data with an in-cabin camera, radar, a connection to the driver's smartwatch, or any combination thereof. The camera may first detect unusual head movements of the driver. This would be done by continuously capturing photographs and/or a continuous video feed of the driver, feeding this data into the one or more first chiplets 206 (for example, operable to carry out a first operation which may be a level 0 operation), storing this data in the one or more memory chiplets 208, and determining by a first of the one or more second chiplets 210 (for example, chiplet 210a operable to carry out second operations which may be level 1 operations) that head movements are unusual. A second of the second chiplets 210b (operable to carry out level 2 operations) may then receive this data and determine that data from the radar must be accessed as well. The radar data being captured with one or more first chiplets 206 and processed with a different one or more second chiplets (for example, second chiplet 210c. The second chiplet 210b operable to carry out the level 2 operation may detect (from data received at the level 1 operation for radar data) that the driver has an unusual heart rate. Finally, a further first chiplet may receive the driver's medical data from the smartwatch and input this into the memory chiplet(s) 208 which can be retrieved by the one or more second chiplet(s) 210 (for example, second chiplet 210d). At a level 1 operation the second chiplet 210d may determine that the driver is currently taking a medication that has a rare side effect increasing blood pressure (for example, by retrieving medical records and/or data fed into the smartwatch). The level 2 operation performed by second chiplet 210b may collaborate these three bits of information - the unusual head movements (from second chiplet 210a), the unusual heart rate (from second chiplet 210c), and that the driver is taking medication with the rare side effect (from second chiplet 210d) - and send this to a further second chiplet (for example, second chiplet 210e) operable to carry out a level 3 operation. The second chiplet 210e may merge all of this data and conclude that an action needs to be taken. The action may be a conclusion that all the captured data together results in having a current threat and, accordingly, triggers a call to the emergency services.

Advantageously, a single device can be implemented in a vehicle which can detect multiple scenarios and adapt the driving of the vehicle for safety or other uses. Each of the second chiplets 210 may include predetermined thresholds to determine specific scenarios and identify each scenario as requiring a certain trigger or not requiring the certain trigger. By providing an electronic circuit package 100, 200 as described herein, each chiplet can easily be replaced if the predetermined thresholds need to be updated. This is much simpler and cheaper than replacing or updating an entire computer system.

In an embodiment, the action may include displaying a message on a user interface (for example, displaying a safety message that the vehicle is approaching an object, indicating that emergency services will be called, etc.), activating a mechanical device (for example, activating the brakes, the steering, the accelerator, or any other component to operate the vehicle; and/or activating in-cabin components to soothe a distressed driver, such as seat massage), and/or deactivating one or more mechanical devices to operate the vehicle and/or soothe the driver. The action may include activating and/or de-activating an electrical device (for example, inner or outer lighting of the vehicle to draw attention to the vehicle, electronic driving controls of the vehicle to take over driving operations and thus avoid a collision, or similar). The action may include requesting data from a network (for example, personal data related to a driver of the vehicle such as if the driver is on any medication and/or has any specific illnesses or other medical conditions). The action may include any combination above. Advantageously, a vehicle (for example, vehicle 400 as described in figure 4) is provided that can react quicker than a vehicle equipped with multiple complex chips. Furthermore, a vehicle is provided that can carry out multiple operations efficiently and effectively (i.e. with a low failure rate due to time lag and, thus, not being able to receive and/or process data quickly).

The electronic circuit package 100, 200 may further include one or more fourth chiplets, one or more fifth chiplets, or up to one or more nth chiplets. Each of the fourth chiplets, the fifth chiplets and the nth chiplets may be of a fourth predetermined type, a fifth predetermined type and an nth predetermined type respectively. Each of the fourth chiplets, the fifth chiplets and the nth chiplets may each include a processor (for example, an MCU or any other suitable processor) operable to carry out a respective fourth, fifth, and nth operation.

In an embodiment, the interposer 204 may include at least one plug operable to receive pins from at least one of the one or more first chiplets 206, the one or more second chiplets 210, the one or more third chiplets, and the one or more memory chiplets 208 (as described above with reference to figure 1). In an embodiment, the at least one plug may be a universal plug. The interposer 204 may have one universal plug operable to receive multiple chiplets (for example, one or more first chiplets 206, one or more second chiplets 210, one or more third chiplets, one or more memory chiplets 208, or any combination thereof). The interposer 204 may have a universal plug for each type of chiplet (for example, a first universal plug for one or more first chiplets 206, a second universal plug for one or more second chiplets 210, a third universal plug for one or more third chiplets, a fourth universal plug for one or more memory chiplets 208, or any combination thereof). The interposer may have a universal plug for each chiplet. At least one of the one or more first chiplets 206, the one or more second chiplets 210, the one or more third chiplets, and the one or more memory chiplets 208 may include pins operable to engage with the at least one universal plug. This provides a simple approach to replacing broken components of the electronic circuit package 100, 200 compared to current complex chips where multiple chips and circuits are soldered to the circuit board and, thus, when a component is damaged the entire chip has to be replaced. This is advantageous because complex chips, especially those in the automotive industry which often have higher processing requirements and tasks/operations specific to the vehicle, are expensive to replace. Therefore, it is advantageous to have universal plugs to be able to replace individual broken chiplets instead of the full circuit. Furthermore, the provided electronic circuit package 100, 200 can easily be upgraded by replacing chiplets on the system with newer chiplets using a "plug and play" arrangement. This increases the longevity of vehicles on the road by allowing older vehicles with previous generation chiplets to easily be upgraded to include the most modern chiplets. By providing a universal plug, chiplets from multiple manufacturers can be used for the same electronic circuit package 100, 200 (provided that the multiple manufacturers use the same plug and pin arrangement). This increases the usability of the electronic circuit package 100, 200 and provides increased manufacturing flexibility to manufacturers vehicles and suppliers of vehicles components.

In an embodiment, the at least one plug is not universal and is dedicated specifically for each type of chiplet (i.e. one or more first chiplet 206, one or more second chiplet 210, one or more third chiplet, one or more memory chiplet 208, or any combination thereof). Accordingly, a chiplet that needs to be replaced can only be replaced by a like-for-like chiplet. Advantageously, the fitment of the pins and the plug(s) can be manufactured to a very small margin which can ensure stronger fitment compared to a universal system. Thus, a risk of one or more chiplets falling off the interposer 204 (for example, during rough driving conditions) is reduced and, thus, the reliability of the electronic integrated circuit package 100, 200 is increased.

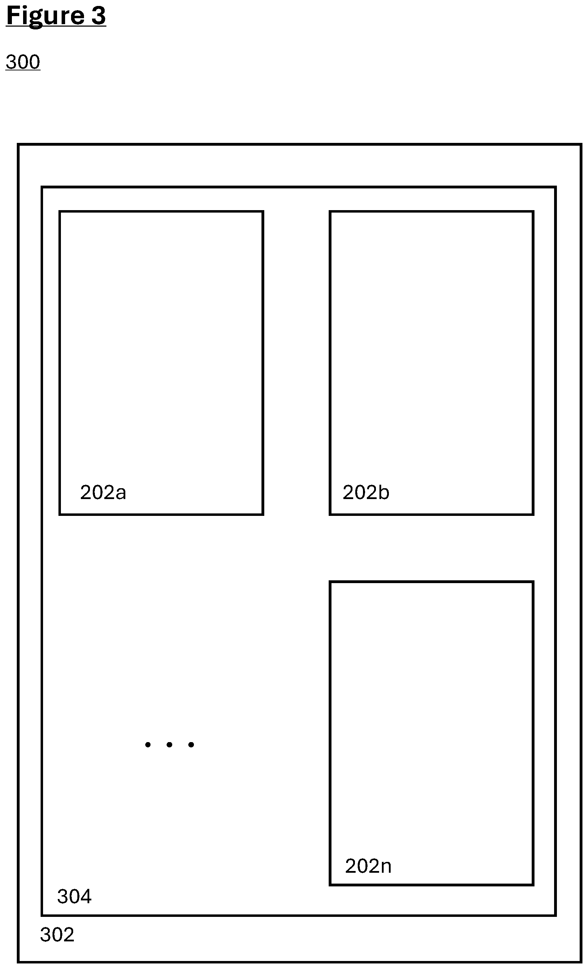

Figure 3 depicts a system 300 of electronic circuit packages (for example, electronic circuit package 100 and 200 described in figures 1 and 2, respectively). The system 300 includes a substrate 302, an interposer 304 disposed on the substrate 302 and a plurality of electronic circuit packages 202a, 202b, ...., 202n disposed on the interposer 304. Each of the plurality of electronic circuit packages 202a, 202b, ..., 202n may be substantially similar to the electronic circuit package 100, 200 described above with reference to figures 1 and 2. The interposer 304 may be coupled to the substrate 302 in a similar manner to the coupling of the interposer 104 to the substrate 102 as described above with reference to figure 1, or the interposer 204 to the substrate 202 as described above with reference to figure 2. Each of the plurality of electronic circuit packages 202a, 202b, ..., 202n may be coupled to the interposer 304 in a similar manner to the coupling of the chiplets 106 to the interposer 104 as described with reference to figure 1, or the chiplets (the first chiplets 206, the second chiplets 210, the memory chiplets 208, the third chiplets) to the interposer 204 as described with reference to figure 2. The coupling of the interposer 304 to the substrate 302 may include a universal plug as described above. The coupling of one or more of the plurality of electronic circuit packages 202a, 202b, ..., 202n may include a universal plug.

Accordingly, each of the plurality of electronic circuit packages 202a, 202b, ..., 202n includes a substrate 202, an interposer 204 disposed on the substrate 202 and one or more first chiplets 206 disposed on the interposer 204, the one or more first chiplets 206 operable to carry out a first operation. Each of the plurality of electronic circuit packages 202a, 202b, ..., 202n includes one or more memory chiplets 208 disposed on the interposer 204, the one or more memory chiplets 208 operable to store data. Each of the plurality of electronic circuit packages 202a, 202b, ..., 202n includes one or more second chiplets 210 disposed on the interposer 204, the one or more second chiplets 210 operable to carry out a second operation.

Although three electronic circuit packages 202a, 202b, ..., 202n are depicted in figure 3, the invention is not limited to three electronic circuit packages and may include any number of electronic circuit packages.

Advantageously, multiple electronic circuit packages 202a, 202b, ..., 202n can be electronically coupled together and can be separated out to perform separate tasks. For example, one electronic circuit package may comprise chiplet types and memory, as described above, to receive sensor data and to process it. A second electronic circuit package may comprise chiplet types and memory dedicated to different operations. Thus, each electronic circuit package may be manufactured to carry out their dedicated tasks efficiently. Therefore, a system can be provided that has an overall even larger processing capacity than current complex chips and current computer systems. Current vehicles require multiple electronic control units (ECUs) to operate multiple different operations of a vehicle. The number of operations required by future vehicles is expected to increase and, thus, it is expected that more processing power will be needed to accommodate all of the operations. With current technology it is expected that this will require vehicles to have even more ECUs. ECUs are expensive to manufacture, and increasing the number of ECUs will increase the cost of a vehicle. Furthermore, additional ECUs add further weight to a vehicle which decreases the vehicle's efficiency. Additional ECUs also require more power to run which further still decreases the vehicle's efficiency. By providing a system 300 as described above, multiple types of operations (typically performed by different ECUs) can be combined into a single unit. This can be done by providing a electronic circuit package (for example as described in figures 1 and 2 above) for each operation and by providing a substrate 302 and interposer 304 as described above to accommodate each of the electronic circuit packages. Accordingly, a central control unit (CCU) is provided that takes up less physical space in a vehicle, requires less power to run and can operate all of the functionalities of the vehicle (for example, vehicle 400 as described in figure 4). Further still, any component that is faulty can be easily located (because the CCU would be in one area of the vehicle, rather than multiple different areas) and can easily be replaced due to the chiplet-style architecture.

Figure 4 depicts a vehicle 400 including at least one sensor (not shown) and an electronic circuit package 402. The vehicle 400 may be a road, off-road, air, amphibious or any other suitable type of vehicle. The electronic circuit package 402 may be the electronic circuit package 100, 200 as described in figures 1 and 2 above. Alternatively, the electronic circuit package 402 may be the system 300 of electronic circuit packages as described in figure 3 above. Advantageously, the vehicle 400 can detect more information quicker (i.e. without lag) and can process this data quicker (i.e. with less lag) to determine which, if any, actions are required. Thus, a vehicle 400 is provided that is more likely to avoid collisions and any other type of accident and/or malfunction as described above. In an embodiment, the sensor may include a radar sensor, a LiDAR sensor, a camera sensor for an advanced driver assistance system (ADAS), or any combination of the above.

## Claims

1. An electronic circuit package for data fusion comprising:
a substrate;
an interposer disposed on the substrate;
one or more first chiplets disposed on the interposer, the one or more first chiplets operable to carry out a first operation;
one or more memory chiplets disposed on the interposer, the one or more memory chiplets operable to store data; and
one or more second chiplets disposed on the interposer, the one or more second chiplets operable to carry out a second operation.

2. The package of claim 1, further comprising:
a first communication infrastructure coupling the one or more first chiplets and the one or more memory chiplets, wherein:
the one or more first chiplets are coupled to the first communication infrastructure in parallel, or
the one or more first chiplets are coupled to the first communication infrastructure in series.

3. The package of claims 1 or 2, further comprising:
a second communication infrastructure coupling the one or more memory chiplets and the one or more second chiplets, wherein:
the one or more second chiplets are coupled to the first communication infrastructure in parallel; or
the one or more second chiplets are coupled to the first communication infrastructure in series.

4. The package of any one of claims 1 to 3, wherein the one or more first chiplets each comprise a first processor operable to carry out the first operation, wherein the first operation comprises receiving data.

5. The package of claim 4, wherein the data comprises:
internal sensor data captured by a vehicle;
external sensor data captured by the vehicle;
data captured by the vehicle;
data received from an external device; or
any combination of the above.

6. The package of claim 5, wherein the sensor data comprises:
video data;
radar data;
LiDAR data; or
any combination of the above.

7. The package of any one of claims 3 to 6, wherein the one or more second chiplets each comprise a second processor operable to carry out the second operation, wherein the second operation comprises classifying the received data into:
One or more categories;
One or more data types; or
A combination of the above.

8. The package of claim 7, wherein the one or more data types comprises:
video data;
sound data;
text data;
radar data;
LiDAR data; or
any combination of the above.

9. The package of claims 7 or 8, wherein the one or more categories comprises:
data comprising information on a user of a vehicle;
data comprising information on the state of the vehicle;
detection of one or more moving objects outside of the vehicle;
detection of one or more stationary objects outside of the vehicle;
detection of one or more moving objects inside the vehicle;
detection of one or more stationary objects inside the vehicle; or
any combination of the above

10. The package of any one of claims 7 to 9, further comprising:
one or more third chiplets, the one or more third chiplets disposed on the interposer and coupled to the second communication infrastructure, the one or more third chiplets each comprise a processor operable to carry out a third operation, and the third operation comprises:
receiving the classified data;
determining, from the classified data, that an action is required by the package; and
instructing a vehicle to carry out the action.

11. The package of claim 10, wherein the action comprises:
displaying a message on a user interface;
activating a mechanical device;
deactivating a mechanical device;
activating an electrical device;
deactivating an electrical device;
requesting data from a network; or
any combination thereof.

12. The package of any one of the above claims, wherein:
the interposer comprises at least one universal plug operable to receive pins from at least one of the one or more first chiplets, the one or more second chiplets, the one or more third chiplets, and the one or more memory chiplets; and
at least one of the one or more first chiplets, the one or more second chiplets, the one or more third chiplets, and the one or more memory chiplets comprises pins operable to engage with the at least one universal plug.

13. A system comprising:
a second substrate;
a second interposer disposed on the second substrate; and
a plurality of packages of claims 1 to 12, the plurality of packages disposed on the second interposer.

14. A vehicle comprising:
a sensor; and
the package of claims 1 to 12 or the system of claim 13.

15. The vehicle of claim 14, wherein the sensor comprises:
a radar sensor;
a LiDAR sensor
a camera sensor for an advanced driver assistance system, ADAS; or
any combination of the above.
